# EUROPÄISCHE PATENTSCHRIFT

(11) **EP 4 122 017 B1**
(45) Veröffentlichungstag und Bekanntmachung des Hinweises auf die Patenterteilung: **01.05.2024**
(21) Anmeldenummer: 21713929.4
(22) Anmeldetag: 18.03.2021
(51) Int. Cl.: H01L 31/0465

(54) **DÜNNSCHICHTSOLARMODUL UND HERSTELLUNGSVERFAHREN**
THIN FILM SOLAR MODULE AND PRODUCTION METHOD
MODULE SOLAIRE À FILMS MINCES ET PROCÉDÉ DE FABRICATION

(30) Priorität: 19.03.2020 DE 102020203510
(43) Veröffentlichungstag der Anmeldung: 25.01.2023
(73) Patentinhaber: NICE Solar Energy GmbH, 74523 Schwäbisch Hall (DE)
(72) Erfinder: WÄCHTER, Rolf, 74523 Schwäbisch Hall (DE); REPMANN, Tobias, 63755 Alzenau (DE); SPRECHER, Bernd, 74523 Schwäbisch Hall (DE)
(74) Vertreter: Patentanwälte Ruff, Wilhelm, Beier, Dauster & Partner mbB
(86) Internationale Anmeldenummer: PCT/EP2021/057013
(87) Internationale Veröffentlichungsnummer: WO 2021/185995

(56) Entgegenhaltungen:
- US-A1- 2011 120 553
- US-A1- 2012 234 366
- US-A1- 2013 299 829
- US-A1- 2017 373 252

## Beschreibung

Die Erfindung bezieht sich auf Dünnschichtsolarmodul mit einem monolithischen Solarzellenarray, das eine Mehrzahl von Solarzellen mit einem Schichtaufbau beinhaltet, der eine Rückkontaktschicht, eine Frontkontaktschicht und eine Absorberschicht zwischen der Rückkontaktschicht und der Frontkontaktschicht umfasst, und mit einer elektrischen Verbindungsstruktur zur elektrisch seriellen Verbindung nebeneinander angeordneter Solarzellen sowie auf ein zugehöriges Herstellungsverfahren.

Derartige Dünnschichtsolarmodule sind in vielerlei Ausführungsarten bekannt. Die Absorberschicht fungiert als photovoltaisch aktive Schicht, die Frontkontaktschicht und die Rückkontaktschicht dienen als elektrische Anschlüsse für den Transport der in der Absorberschicht durch den photovoltaischen Effekt erzeugten und getrennten elektrischen Ladungen. Zusätzlich zu diesen drei Schichten umfasst der Schichtaufbau meist noch eine oder mehrere weitere Schichten, wie eine Pufferschicht, eine Barrierenschicht etc., die vorliegend nicht von Interesse sind und daher nicht eigens erwähnt werden.

Mit der Frontkontaktschicht und der Rückkontaktschicht sind vorliegend sowohl die eigentliche, ganzflächig an die Absorberschicht angrenzende Frontkontaktschichtlage bzw. Rückkontaktschichtlage als auch etwaige zusätzliche elektrische Kontaktstrukturen gemeint, die auf der Frontkontaktschichtlage bzw. der Rückkontaktschichtlage an deren der Absorberschicht abgewandten Seite herkömmlicherweise vorgesehen sein können, um die elektrische Anbindung des Solarzellenarrays nach außen zu begünstigen. Mit Frontkontaktschicht ist hierbei wie üblich diejenige der beiden elektrischen Kontaktschichten gemeint, die sich auf der Lichteinfallseite des Solarmoduls bzw. Solarzellenarrays befindet, d.h. dem Lichteinfall zugewandt ist. Aus diesem Grund besteht die Frontkontaktschichtlage typischerweise aus einem möglichst gut elektrisch leitenden, hoch lichttransparenten Material, meist ein transparentes, elektrisch leitfähiges Oxidmaterial, und auf diese Frontkontaktschichtlage ist eine sogenannte Kontaktgridstruktur bzw. Kontaktgitterstruktur mit Kontaktfingern aus einem elektrisch hoch leitfähigen, jedoch lichtundurchlässigen Metallmaterial aufgebracht. Die Kontaktgridstruktur soll durch ihren niedrigen ohmschen Widerstand für einen möglichst ungehinderten und über die Fläche des Solarzellenarrays hinweg gleichmäßigen Ladungs- bzw. Stromtransport sorgen und dabei die nutzbare Lichteinfallsfläche für die Absorberschicht möglichst wenig reduzieren.

Durch die elektrische Verbindungsstruktur sind nebeneinander angeordnete Solarzellen des Solarzellenarrays elektrisch seriell verbunden, d.h. elektrisch in Reihe geschaltet. Durch entsprechende Gestaltung der elektrischen Verbindungsstruktur können eine beliebige Anzahl der im Solarzellenarray vorhandenen Solarzellen, bis hin zu allen Solarzellen des Arrays, elektrisch seriell verschaltet sein. Dabei können in entsprechenden Ausführungen eines Dünnschichtsolarmoduls oftmals Blöcke von dergestalt seriell verschalteten Zellen eines Arrays oder zweier getrennter Arrays ihrerseits elektrisch parallel geschaltet sein.

Hierzu ist es als eine monolithisch integrierte Ausführung der elektrischen Verbindungsstruktur bekannt, die Rückkontaktschicht einer jeweiligen Solarzelle mit der Frontkontaktschicht einer benachbarten Solarzelle mittels einer Verbindungs- bzw. Kontaktschichtstruktur zu verbinden, die während der Bildung des Solarzellenarrays durch entsprechende Schichtbildungs- und Schichtstrukturierungsprozesse gebildet wird, z.B. gleichzeitig mit der Frontkontaktschicht und unter Verwendung des für die Frontkontaktschicht verwendeten Schichtmaterials. Zur Herstellung dieser monolithisch integrierten elektrischen Verbindungsstruktur zur seriellen Verschaltung der Solarzellen ist beispielsweise die sogenannte P1-P2-P3-Strukturierungstechnik geläufig, wie sie unter anderem in der Patentschrift DE 199 34 560 B4 und in dem Lehrbuch "Handbook of Photovoltaic Science and Engineering", 2. Auflage, Seiten 585 bis 587, ISBN 978-0-470-72169-8 beschrieben ist.

Die Offenlegungsschrift US 2017/0373252 A1 offenbart ein organisches Dünnschicht-Solarzellenarray mit monolithisch integrierter Serienverschaltung der Solarzellen, bei dem die Absorberschicht aus einem organischen Material und die Rück- und Frontkontaktschichten aus einem elektrisch leitfähigen Polymermaterial bestehen, das durch Aufheizen mittels Laserstrahlung in elektrisch isolierendes Material transformiert werden kann, was dort dazu genutzt wird, entsprechende Isolationsbereiche nach Art einer P1-P2-P3-Strukturierung zum Separieren benachbarter Solarzellen und zum Isolieren elektrischer Verbindungsstrukturen gegenüber benachbarten, elektrisch leitenden Schichtbereichen herzustellen. Zur Serienverschaltung der Zellen sind dort Kontaktstreifen gebildet, die sich in Reihenschaltungsrichtung über der Frontkontaktschicht zweier benachbarter Zellen erstrecken, wobei der jeweilige Kontaktstreifen die Frontkontaktschicht der einen Zelle direkt kontaktiert und vom aktiven Frontkontakt- und Absorberschichtbereich der anderen Zelle mittels Seitenisolationsbereichen elektrisch isoliert ist und sich über ein dort gebildetes Kontaktloch zur Rückkontaktschicht erstreckt.

Die Offenlegungsschrift US 2012/0204930 A1 offenbart ein Dünnschichtsolarmodul mit einer P1-P2-P3-Strukturierungstechnik, bei der als Alternative zu üblichen durchgängigen Strukturierungslinien rechteckförmige Verbindungsbereiche zur Serienverschaltung der Solarzellen vorgesehen sind.

Dem Fachmann ist geläufig, dass die Dimensionierung bzw. das Design der Solarzellen und ihrer Serienverbindungsstruktur bei Dünnschichtsolarmodulen wesentlichen Einfluss auf den Wirkungsgrad des Moduls hat. Dabei zeigt sich, dass üblicherweise der Wirkungsgrad als Funktion der Zellenweite, d.h. der Längenausdehnung der jeweiligen Solarzelle in Reihenschaltungsrichtung, einen Verlauf besitzt, der bei einer bestimmten Zellenweite ein Maximum besitzt und von diesem zu beiden Seiten, d.h. mit geringer werdender bzw. größer werdender Zellenweite abnimmt, wobei die Lage dieses Wirkungsgradmaximums von den sonstigen Modulparametern abhängt und in der Regel bei einer Zellenweite im Bereich zwischen ca. 0,2 cm und ca. 1 cm liegt. Entsprechende Untersuchungen bzw. Resultate finden sich beispielsweise in dem Zeitschriftenaufsatz Y. Gupta et al., Optimization of a-Si Solar Cell Current Collection, Proc. of the 16th IEEE Photovoltaic Specialists Conf., S. 1092, 1982.

In einer alternativen Verbindungstechnik werden je zwei Solarzellen mittels extern angebrachter Kontaktstreifen aus einem metallischen, elektrisch hoch leitfähigen Draht- oder Bandmaterial dadurch elektrisch seriell verschaltet, dass der jeweilige Kontaktstreifen entlang der Rückseite der einen Solarzelle und entlang der Frontseite der anderen Solarzelle angebracht wird, wobei er zwischen den beiden nebeneinander liegenden Solarzellen von der Rückseite zur Frontseite geführt ist, wozu die beiden Solarzellen einen entsprechenden Durchlassspalt zwischen sich belassen. Diese Verbindungstechnik eignet sich vor allem für Dünnschichtsolarmodule in flexibler Ausführung ohne starres, rückseitiges Trägersubstrat bzw. für Ausführungen, bei denen die Rückkontaktschicht von der Modulrückseite her elektrisch kontaktiert werden kann bzw. soll. Diese Verbindungstechnik ist beispielsweise in der Dissertation "Siebdruck der Frontseitenmetallisierung und der Klebeflächen für Zellverbinder auf a-Si:H/c-Si-Heterojunction-Solarzellen" von R. Friedrich, Seiten 14 und 15 sowie in den Offenlegungsschriften EP 1 708 281 A2, EP 1 748 495 A1 und WO 2006/101741 A2 offenbart.

Ein weiteres herkömmliches Dünnschichtsolarmodul mit einer Serienverschaltung von nebeneinander platzierten Solarzellen unter Verwendung von Kontaktstreifen ist in der Offenlegungsschrift DE 10 2014 116 498 A1 offenbart, wobei dort die Kontaktstreifen zur Rückkontaktschichtkontaktierung vorderseitig in randnahe, die Rückkontaktschicht freilegende Aussparungen der betreffenden Solarzelle geführt sind.

Weitere herkömmliche Dünnschichtsolarmodule mit einer Serienverschaltung von nebeneinander platzierten Solarzellen und zugehörige Herstellungsverfahren sind in den Offenlegungsschriften US 2013/0299829 A1 und US 2011/0120553 A1 offenbart.

Der Erfindung liegt als technisches Problem die Bereitstellung eines Dünnschichtsolarmoduls der eingangs genannten Art, das sich mit vergleichsweise geringem Aufwand fertigen lässt, einen hohen Solarmodulwirkungsgrad ermöglicht, niedrige Stromtransportverluste besitzt und bei Bedarf die Erzielung relativ kleiner Modulspannungen durch serielles Verschalten von verhältnismäßig wenigen und vergleichsweise großflächigen Solarzellen erlaubt, und eines vorteilhaften Verfahrens zur Herstellung eines solchen Dünnschichtsolarmoduls zugrunde.

Die Erfindung löst dieses Problem durch die Bereitstellung eines Dünnschichtsolarmoduls mit den Merkmalen des Anspruchs 1 und eines Herstellungsverfahrens mit den Merkmalen des Anspruchs 11. Vorteilhafte Weiterbildungen der Erfindung sind in den Unteransprüchen angegeben.

Beim erfindungsgemäßen Dünnschichtsolarmodul beinhaltet die elektrische Verbindungsstruktur Kontaktstreifen zur elektrisch seriellen Verbindung nebeneinander angeordneter Solarzellen, wobei die elektrische Verbindungsstruktur je zwei in einer Reihenschaltungsrichtung aneinandergrenzende Solarzellen durch einen oder mehrere Kontaktstreifen miteinander elektrisch seriell verbindet. Die Kontaktstreifen sind quer zur Reihenschaltungsrichtung voneinander beabstandet angeordnet und verlaufen mit einer Richtungskomponente in der Reihenschaltungsrichtung in Verbindungsstreifenbereichen der Solarzellen, d.h. sie verlaufen parallel oder unter einem spitzen Winkel kleiner als 90° zu der Reihenschaltungsrichtung. Jeder Kontaktstreifen kontaktiert eine der Absorberschicht zugewandte Seite der Rückkontaktschicht der einen Solarzelle und eine der Absorberschicht abgewandte Seite der Frontkontaktschicht der anderen Solarzelle, wobei die Verbindungsstreifenbereiche der Solarzellen Verbindungsaussparungen in der Frontkontaktschicht und der Absorberschicht zur Freilegung der absorberschichtzugewandten Seite der Rückkontaktschicht aufweisen. Die jeweilige Verbindungsaussparung kann z.B. von einem durchgehenden Verbindungsgraben oder von einem oder mehreren beabstandeten Durchkontaktöffnungen gebildet sein.

Durch Anordnen mehrerer, voneinander beabstandeter Kontaktstreifen zur seriellen Verbindung der jeweiligen beiden Solarzellen lässt sich ein guter Ladungs- bzw. Stromtransport auch bei großflächigeren Solarzellen sicherstellen. In gleicher Weise trägt dazu die Möglichkeit bei, dass sich der jeweilige Kontaktstreifen entlang der Reihenschaltungsrichtung, in welcher die beiden seriell verbundenen Solarzellen nebeneinander angeordnet sind, über eine beliebige Länge hinweg im Bereich der jeweiligen Solarzelle erstrecken kann. Der Kontaktstreifen kann sich dementsprechend über einen merklichen Teil der Ausdehnung der Solarzellen in dieser Reihenschaltungsrichtung hinweg erstrecken, und seine Erstreckung ist insbesondere nicht auf einen Randbereich der Solarzelle beschränkt. Das trägt zu einer Minimierung der ohmschen Widerstände der stromleitenden Strukturen des Moduls bei. Da die Kontaktstreifen die Rückkontaktschicht der betreffenden Solarzelle auf deren der Absorberschicht zugewandten Seite kontaktieren, ist keine rückwärtige Zugänglichkeit der Rückkontaktschicht von deren der Absorberschicht abgewandten Seite her erforderlich. In vielen Fällen ist es bevorzugt, wenn die Kontaktstreifen parallel zur zugehörigen Reihenschaltungsrichtung der Solarzellen verlaufen, jedoch kann es je nach Bedarf und Anwendungsfall alternativ günstig sein, wenn die Kontaktstreifen nicht genau parallel zu dieser Reihenschaltungsrichtung verlaufen, sondern schräg dazu.

Erfindungsgemäß verläuft der jeweilige Kontaktstreifen im Verbindungsstreifenbereich auf der Frontkontaktschicht der einen Solarzelle und in einem die Verbindungsaussparung bildenden Verbindungsgraben der anderen Solarzelle und kontaktiert die Rückkontaktschicht der anderen Solarzelle entlang seiner Erstreckung über der Rückkontaktschicht durchgehend, wobei er sich zwischen den zugeordneten Solarzellen über den diese separierenden Trennstreifenbereich hinweg unter Zwischenfügung einer Isolationsschicht erstreckt. Mit durchgehender Kontaktierung ist hierbei vorliegend gemeint, dass der Kontaktstreifen im Verbindungsgraben durchgehend mit Berührkontakt gegen die Rückkontaktschicht anliegt, so dass durch die Verwendung elektrisch leitfähiger Materialien grundsätzlich auch ein entsprechend durchgängiger elektrischer Kontakt gegeben ist. Bei Bedarf kann die elektrische Kontaktierung z.B. durch Verwendung von Ultraschallschweißpunkten oder dgl. zusätzlich punktuell verstärkt bzw. unterstützt werden. Dabei ist der jeweilige Kontaktstreifen als vorgefertigtes Draht- oder Bandmaterial angebracht und/oder seine Kontaktfläche zur Rückkontaktschicht besitzt ein Länge/Breite-Verhältnis von mindestens 3:1, bevorzugt mindestens 5:1 oder mindestens 10:1 oder mindestens 30:1 oder mindestens 100:1. Zusätzlich oder alternativ zu dieser Länge/Breite-Dimensionierung des Kontaktstreifens kann der Verbindungsgraben in gleicher Weise ein Länge/Breite-Verhältnis von mindestens 3:1, bevorzugt mindestens 5:1 oder mindestens 10:1 oder mindestens 30:1 oder mindestens 100:1, besitzen. Die Isolationsschicht verhindert in dieser Ausführung, dass der Kontaktstreifen im Trennstreifenbereich unerwünschterweise mit einer im Trennstreifenbereich freiliegenden Seitenflanke, d.h. Randseite bzw. Schmalseite, der Rückkontaktschicht und/oder der Absorberschicht derjenigen Solarzelle elektrisch in Kontakt kommt, deren Frontkontaktschicht er kontaktiert.

Diese elektrische Verbindungsstruktur gemäß der Erfindung stellt ein vorteilhaftes Verschaltungskonzept zur seriellen Verschaltung der Solarzellen des monolithischen Solarzellenarrays dar. Das Verschaltungskonzept ermöglicht einen optimalen Kompromiss zwischen Verlusten an photovoltaisch nutzbarer Lichteinfallsfläche und elektrischen Widerstandsverlusten. Stromtransportverluste können minimal gehalten werden, und der Wirkungsgrad der einzelnen Solarzellen kann mit sehr hoher Effizienz in das Gesamtmodul übertragen werden, d.h. für das Gesamtmodul beibehalten werden. Die Verbindungsstruktur kann mit relativ geringem Aufwand gefertigt werden und ermöglicht eine Serienverschaltung von in herkömmlicher Weise monolithisch zusammenhängenden und nur durch entsprechende Trenn- bzw. Strukturierungslinien voneinander separierten Solarzellen. Die Solarzellen können relativ großflächig ausgeführt sein, um bei gegebener Gesamtzellenfläche eine relativ niedrig bleibende Modulspannung als Summe der Einzelspannungen der seriell verschalteten Solarzellen zu erzielen. Insbesondere zeigt sich, dass dieses Verschaltungskonzept Module mit Solarzellen relativ großer Zellenweite, vorliegend auch Zellenbreite bezeichnet, in Reihenschaltungsrichtung bei gleichzeitig relativ hohem Modulwirkungsgrad, d.h. Wirkungsgrad des Solarmoduls hinsichtlich seines photoelektrischen Umwandlungsvermögens, ermöglicht. Die Erfindung lässt sich für Dünnschichtsolarmodule vom CIGS(Kupfer-Indium-Gallium-Diselenid)-Typ und für Dünnschichtsolarmodule anderer herkömmlicher Typen verwenden.

In einer Weiterbildung der Erfindung beträgt eine Zellenbreite, i.e. Zellenweite, der jeweiligen Solarzelle in der Reihenschaltungsrichtung mindestens 2cm, insbesondere mindestens 3cm. Dies ist eine verglichen mit üblichen Zellenweiten relativ große Zellenweite. Dennoch ermöglicht die Erfindung aufgrund der speziellen erfindungsgemäßen Serienverschaltungsmaßnahmen die Erzielung eines Wirkungsgrades des Dünnschichtsolarmoduls von mindestens 14%, insbesondere mindestens 16%. Zusätzlich oder alternativ liegt ein Maximum des Wirkungsgrades des Dünnschichtsolarmoduls als Funktion einer Zellenweite der jeweiligen Solarzelle in der Reihenschaltungsrichtung in einem Bereich der Zellenweite zwischen 2cm und 10cm, und/oder der Wirkungsgrad des Dünnschichtsolarmoduls als Funktion der Zellenweite der jeweiligen Solarzelle in der Reihenschaltungsrichtung schwankt im Bereich der Zellenweite zwischen 2cm und 20cm um relativ betrachtet höchstens 20%, insbesondere um höchstens 10% relativ.

Mit anderen Worten ermöglicht diese Weiterbildung die Bereitstellung eines Moduls mit relativ großer Zellenweite und gleichzeitig relativ hohem Wirkungsgrad, wobei sich zudem die Zellenweite in einem relativ großen Bereich variieren lässt, speziell auch in Richtung größer werdender Zellenweite, ohne den Wirkungsgrad so stark zu verringern, dass das Modul für den praktischen Einsatz nicht mehr tauglich erscheint. In der Regel ist die Zellenweite aller Solarzellen des Moduls einheitlich gleich groß gewählt, für entsprechende Anwendungen ist es jedoch auch möglich, die Zellenweite mindestens einer Solarzelle verschieden von der Zellenweite mindestens einer anderen Solarzelle des Moduls zu wählen, wobei dann die oben genannten Dimensionierungsangaben für die Zellenweite bei derartigen Weiterbildungen der Erfindung für mindestens eine der Solarzellen des Moduls gelten, vorzugsweise für eine überwiegende Anzahl aller Zellen und bevorzugt für alle Zellen.

In einer Weiterbildung der Erfindung grenzen eine erste und eine dritte Solarzelle auf gegenüberliegenden Seiten an eine zweite Solarzelle an, wobei die erste und die zweite Solarzelle durch einen oder mehrere erste Kontaktstreifen elektrisch seriell verbunden sind und die zweite und die dritte Solarzelle durch einen oder mehrere zweite Kontaktstreifen elektrisch seriell verbunden sind. Jeder der ersten Kontaktstreifen kontaktiert die absorberschichtzugewandte Seite der Rückkontaktschicht der ersten Solarzelle und die absorberschichtabgewandte Seite der Frontkontaktschicht der zweiten Solarzelle, und jeder der zweiten Kontaktstreifen kontaktiert die absorberschichtzugewandte Seite der Rückkontaktschicht der zweiten Solarzelle und die absorberschichtabgewandte Seite der Frontkontaktschicht der dritten Solarzelle, wobei sich im Bereich der zweiten Solarzelle mindestens ein erster und ein zweiter Kontaktstreifen in Richtung quer zur Reihenschaltungsrichtung überlappend erstrecken.

Diese Weiterbildung bietet eine vorteilhafte Grundlage zur seriellen Verschaltung einer beliebigen Anzahl von Solarzellen in einem entsprechenden String, d.h. einer kettenartigen Abfolge, von seriell verschalteten Solarzellen im monolithischen Solarzellenarray. Im Bereich der jeweiligen Solarzelle können sich die ersten und die zweiten Kontaktstreifen in Richtung quer zur Reihenschaltungsrichtung überlappend, d.h. ineinandergreifend, erstrecken. Insbesondere lassen sich mit dieser Weiterbildung eine beliebige Anzahl von Solarzellen, die in einer geradlinigen Reihe nebeneinanderliegend angeordnet sind, seriell verschalten. Dabei überlappen im Bereich einer jeweiligen Solarzelle, die an zwei gegenüberliegenden Seiten mit je einer weiteren Solarzelle elektrisch seriell verbunden ist, mindestens einer, bevorzugt mehrere und in einer besonders vorteilhaften Realisierung alle Kontaktstreifen, die zu der einen angrenzenden Solarzelle geführt sind, mit den benachbarten Kontaktstreifen, die zu der anderen, gegenüberliegend angrenzenden Solarzelle geführt sind.

Dadurch lässt sich eine ineinandergreifende, überlappende Kontaktstreifenstruktur realisieren, bei der sich die zu einer ersten benachbarten Solarzelle führenden Kontaktstreifen in die Bereiche zwischen den zu einer gegenüberliegend benachbarten zweiten Solarzelle geführten Kontaktstreifen hinein erstrecken. Dies trägt zur weiteren Optimierung der elektrischen Verbindungsstruktur für in einer Reihe nebeneinanderliegend angeordneten und elektrisch seriell verschalteten Solarzellen bei. In alternativen Ausführungen erstrecken sich die einen Kontaktstreifen, welche eine betrachtete Solarzelle mit einer ersten benachbarten Solarzelle kontaktieren, nicht bis in den Bereich zwischen zwei benachbarten anderen Kontaktstreifen hinein, mit denen die betrachtete Solarzelle mit der gegenüberliegend benachbarten zweiten Solarzelle elektrisch seriell verschaltet ist.

In einer Ausgestaltung der Erfindung sind im Bereich der jeweiligen Solarzelle die ersten Kontaktstreifen mit gleichem Querabstand voneinander angeordnet. Diese gleiche Querbeabstandung der ersten Kontaktstreifen voneinander begünstigt in der Regel eine optimale Stromaufnahme bzw. Stromabnahme aus der bzw. in die betreffende Solarzelle und damit einen optimalen Stromtransport über die Flächenausdehnung der Solarzelle hinweg. In weiterer Ausgestaltung der Erfindung beträgt der Querabstand der ersten Kontaktstreifen voneinander zwischen 10mm und 100mm, was sich in sehr vielen Anwendungen als optimal erweist. Alternativ kann in bestimmten Fällen eine Beabstandung der ersten Kontaktstreifen voneinander mit unterschiedlichen Querabständen vorgesehen sein.

In einer anderweitigen Ausgestaltung der Erfindung sind die zweiten Kontaktstreifen mit gleichem Querabstand voneinander angeordnet. Auch in diesem Fall ist die gleiche Querbeabstandung der zweiten Kontaktstreifen voneinander für die meisten Fälle optimal, jedoch kann für bestimmte Fälle alternativ eine Anordnung der zweiten Kontaktstreifen mit unterschiedlichen Querabständen voneinander vorgesehen sein. In weiterer Ausgestaltung der Erfindung beträgt der Querabstand der zweiten Kontaktstreifen voneinander zwischen 10mm und 1 00mm, was sich in sehr vielen Anwendungen als optimal erweist.

In noch einer anderen Ausgestaltung der Erfindung sind die ersten und die zweiten Kontaktstreifen alternierend mit gleichem Querabstand voneinander angeordnet. Dies stellt eine maximal gleichmäßige Anordnung und Verteilung der ersten und zweiten Kontaktstreifen auf der jeweiligen Solarzelle dar, wobei in diesem Fall die ersten und zweiten Kontaktstreifen vorzugsweise in der erwähnten ineinandergreifenden Struktur angeordnet sind. In weiterer Ausgestaltung der Erfindung beträgt der Querabstand der ersten und zweiten Kontaktstreifen voneinander zwischen 5mm und 50mm, was sich in sehr vielen Anwendungen als optimal erweist. Alternativ kann für gewisse Fälle eine Anordnung der ersten und zweiten Kontaktstreifen auf der jeweiligen Solarzelle vorgesehen sein, bei der unterschiedliche Querabstände vorgesehen sind und/oder von der alternierenden Anordnung der ersten und zweiten Kontaktstreifen abgewichen wird, z.B. durch Anordnen je zweier zweiter Kontaktstreifen zwischen zwei ersten Kontaktstreifen oder durch eine anderweitige Abfolge der ersten und zweiten Kontaktstreifen in der Querrichtung der Solarzelle quer zu Reihenschaltungsrichtung.

In einer Weiterbildung der Erfindung weist das Solarzellenarray eine Substratschicht auf, auf der die Solarzellen mit ihrer Rückkontaktschicht der Substratschicht zugewandt gemeinsam angeordnet sind, wobei je zwei nebeneinanderliegende und elektrisch seriell verbundene Solarzellen in ihrem Schichtaufbau durch einen Trennstreifenbereich voneinander separiert sind und sich die Kontaktstreifen zur elektrisch seriellen Verbindung der beiden Solarzellen über deren Trennstreifenbereich hinweg erstrecken. Diese Weiterbildung eignet sich für Module mit einer an sich bekannten monolithischen Verschaltung des Solarzellenarrays, bei dem die einzelnen Solarzellen durch die Trennstreifenbereiche voneinander separiert sind. Die Kontaktstreifen erstrecken sich in diesem Fall zur elektrisch seriellen Verbindung zweier entlang des Trennstreifenbereichs benachbarter Solarzellen über diesen Trennstreifenbereich hinweg.

In einer Weiterbildung der Erfindung sind die Kontaktstreifen getrennt vom monolithischen Solarzellenarray gefertigte und am monolithischen Solarzellenarray angebrachte Bauteile. Die Kontaktstreifen können in diesem Fall z.B. als einzelne Kontaktdrähte oder Kontaktbänder vorgefertigt sein, die dann auf die Solarzellen aufgebracht und mechanisch und elektrisch mit der Frontkontaktschicht der einen Solarzelle und der Rückkontaktschicht der mit dieser seriell zu verbindenden, benachbarten Solarzelle verbunden werden, z.B. durch einen Lötvorgang oder unter Verwendung eines elektrisch leitfähigen Klebematerials. Alternativ können die Kontaktstreifen in einem geeigneten herkömmlichen Schichtbildungs- und Schichtstrukturierungsprozess zum Aufbringen und Strukturieren der Kontaktstreifen als elektrisch leitfähige Dünnschichtstreifen realisiert sein.

In einer Weiterbildung der Erfindung erstrecken sich die Kontaktstreifen im Bereich einer jeweiligen Solarzelle mit einer Streifenlänge, die mindestens 50%, insbesondere mindestens 80%, der Längenausdehnung der Solarzelle in der Erstreckungsrichtung der Kontaktstreifen beträgt. Diese relativ große Streifenlänge der Kontaktstreifen bezogen auf die Längenausdehnung der Solarzelle begünstigt eine ganzflächige und gleichmäßige Stromtransportcharakteristik der elektrischen Verbindungsstruktur über die Flächenausdehnung der Solarzellen hinweg, wobei die ohmschen Widerstände für den Stromtransport minimiert werden können. In Ausnahmefällen kann es alternativ gewünscht sein, die Erstreckungslänge der Kontaktstreifen geringer zu wählen.

In einer Weiterbildung der Erfindung erstrecken sich die Kontaktstreifen im Bereich einer jeweiligen Solarzelle mit ihrem die Frontkontaktschicht kontaktierenden Streifenabschnitt mit einer Streifenlänge, die gegenüber der Längenausdehnung der Solarzelle in der Erstreckungsrichtung der Kontaktstreifen um einen Verkürzungsabstand geringer ist, der höchstens doppelt so groß, insbesondere höchstens so groß, ist wie ein Gridabstand einer Kontaktgridstruktur der Frontkontaktschicht. Diese Maßnahme hat den Vorteil, dass in diesen Fällen, in denen die Frontkontaktschicht eine Kontaktgridstruktur aufweist, der jeweilige Kontaktstreifen alle oder fast alle Kontaktfinger bzw. Kontaktbahnen dieser Kontaktgridstruktur direkt kontaktieren kann, d.h. mit diesen in Berührkontakt stehen kann, was den Ladungs- bzw. Stromtransport an der Frontkontaktschicht optimiert und die ohmschen Widerstände gering hält. In Ausnahmefällen kann es alternativ gewünscht sein, die Erstreckungslänge der Kontaktstreifen geringer zu wählen, d.h. um mehr als das Doppelte des Gridabstands kürzer als die Längenausdehnung der Solarzelle in dieser Richtung.

In einer Ausgestaltung der Erfindung beträgt die Längenausdehnung der jeweiligen Solarzelle in der Erstreckungsrichtung der Kontaktstreifen zwischen 10mm und 300mm. Dies stellt für sehr viele Anwendungen eine optimale Dimensionierung der Ausdehnung der einzelnen Solarzellen des Solarzellenarrays dar. Alternativ können aber auch Solarzellen mit geringerer oder größerer Längenausdehnung vorgesehen sein.

In einer Weiterbildung der Erfindung liegt das Länge/Breite-Verhältnis der Kontaktfläche des jeweiligen Kontaktstreifens zur Rückkontaktschicht im Bereich zwischen 15:1 und 1000:1, wenn eine Zellenweite (ZB) der Solarzelle zwischen 0,5 cm und 30 cm beträgt. Dies stellt eine für viele Anwendungen optimal auf die Zellenweite der Solarzelle abgestimmte Wahl des Länge/Breite-Verhältnisses dieser Kontaktfläche dar.

Beim erfindungsgemäßen Herstellungsverfahren wird zunächst das monolithische Solarzellenarray vorfertigt, was durch beliebige herkömmliche, dem Fachmann hierzu geläufige Herstellungsprozesstechniken und Herstellungsprozessschritte erfolgen kann. Anschließend werden die Verbindungsaussparungen in der Frontkontaktschicht und der Absorberschicht gebildet, um die Rückkontaktschicht im betreffenden Bereich freizulegen, z.B. durch einen üblichen Prozess zur Bildung von Gräben oder Durchkontaktöffnungen. Dann werden die Kontaktstreifen angebracht, z.B. durch einen Schichtdepositionsprozess oder als vorgefertigtes Streifenmaterial, z.B. als einzelne Drahtstücke bzw. Kontaktbänder aus einem elektrisch leitfähigen Material, und elektrisch mit der Rückkontaktschicht und der Frontkontaktschicht der jeweils zugehörigen Solarzellen kontaktiert. Abschließend wird das Dünnschichtsolarmodul durch übliche weitere Prozessschritte je nach gewünschtem Ausführungstyp des Moduls fertiggestellt, z.B. zum Herstellen äußerer Kontaktanschlüsse und/oder zum Verkapseln des Moduls. Insgesamt ermöglicht dies die Herstellung des erfindungsgemäßen Dünnschichtsolarmoduls mit relativ hoher Fertigungseffizienz und relativ geringem Fertigungsaufwand.

In einer Weiterbildung der Erfindung wird zur Realisierung der Variante, bei welcher der jeweilige Kontaktstreifen im Verbindungsstreifenbereich unter Zwischenfügung einer Isolationsschicht auf der Frontkontaktschicht verläuft und die Rückkontaktschicht der betreffenden Solarzelle entlang seiner Erstreckung in einem oder mehreren voneinander beabstandeten Kontaktabschnitten kontaktiert, vor dem Bilden der Verbindungsaussparungen und dem Anbringen der Kontaktstreifen die Isolationsschicht in den Verbindungsstreifenbereichen auf der Frontkontaktschicht aufgebracht, z.B. durch eine Schichtdepositionstechnik oder als vorgefertigtes Streifenmaterial.

In einer Weiterbildung der Erfindung werden die Kontaktstreifen getrennt vom monolithischen Solarzellenarray vorgefertigt und am monolithischen Solarzellenarray angebracht. Das erweist sich für viele Anwendungen als herstellungstechnisch günstig. Vorteilhafte Ausführungsformen der Erfindung sind in den Zeichnungen 1-5, 7, 9-12 und 17 dargestellt. Andere Ausführungen, nicht Teil der Erfindung, sind in den Zeichnungen 6, 8 und 13-16 dargestellt. Diese und weitere vorteilhafte Ausführungsformen der Erfindung werden nachfolgend näher beschrieben. Hierbei zeigen:
- Fig. 1: eine Draufsicht auf ein Dünnschichtsolarmodul mit zwanzig seriell verschalteten Solarzellen in zwei Reihen,
- Fig. 2: eine Draufsicht auf ein Dünnschichtsolarmodul mit vierzig seriell verschalteten Solarzellen in vier Reihen,
- Fig. 3: eine Draufsicht auf ein Dünnschichtsolarmodul mit sechzig seriell verschalteten Solarzellen in sechs Reihen,
- Fig. 4: eine Detailansicht eines Bereichs IV in Fig. 3,
- Fig. 5: eine ausschnittweise Draufsicht auf ein Dünnschichtsolarmodul nach Art der Fig. 1 bis 3 in einer Ausführung mit durchgehender Kontaktierung von Kontaktstreifen mit einer Rückkontaktschicht,
- Fig. 6: die Ansicht von Fig. 5 für eine Ausführung mit punktueller Kontaktierung der Kontaktstreifen mit der Rückkontaktschicht,
- Fig. 7: eine Schnittansicht längs einer Linie VII-VII in Fig. 5,
- Fig. 8: eine Schnittansicht längs einer Linie VIII-VIII in Fig. 6,
- Fig. 9: eine Schnittansicht längs einer Linie IX-IX in Fig. 5,
- Fig. 10: eine Schnittansicht längs einer Linie X-X in Fig. 5,
- Fig. 11: eine Schnittansicht längs einer Linie XI-XI in Fig. 5,
- Fig. 12: eine Schnittansicht längs einer Linie XII-XII in Fig. 5,
- Fig. 13: eine Schnittansicht längs einer Linie XIII-XIII in Fig. 6,
- Fig. 14: eine Schnittansicht längs einer Linie XIV-XIV in Fig. 6,
- Fig. 15: eine Schnittansicht längs einer Linie XV-XV in Fig. 6,
- Fig. 16: eine Schnittansicht längs einer Linie XVI-XVI in Fig. 6 und
- Fig. 17: ein Diagramm des Modulwirkungsgrades als Funktion der Zellenweite für ein exemplarisches Moduldesign.

Das in den Figuren in verschiedenen Ausführungsvarianten gezeigte Dünnschichtsolarmodul umfasst ein monolithisches Solarzellenarray 1, das eine Mehrzahl von Solarzellen 2 mit einem Schichtaufbau beinhaltet, der eine Rückkontaktschicht 3, eine Frontkontaktschicht 4 und eine Absorberschicht 5 zwischen der Rückkontaktschicht 3 und der Frontkontaktschicht 4 aufweist. Des Weiteren beinhaltet das Dünnschichtsolarmodul eine elektrische Verbindungsstruktur 6 mit Kontaktstreifen 7 zur elektrisch seriellen Verbindung nebeneinander angeordneter Solarzellen, wobei die elektrische Verbindungsstruktur je zwei in einer Reihenschaltungsrichtung RS aneinandergrenzende Solarzellen 2ₘ₋₁ und 2ₘ, 2ₘ und 2ₘ₊₁ etc. durch einen oder wie gezeigt mehrere der Kontaktstreifen 7 miteinander elektrisch seriell verbindet.

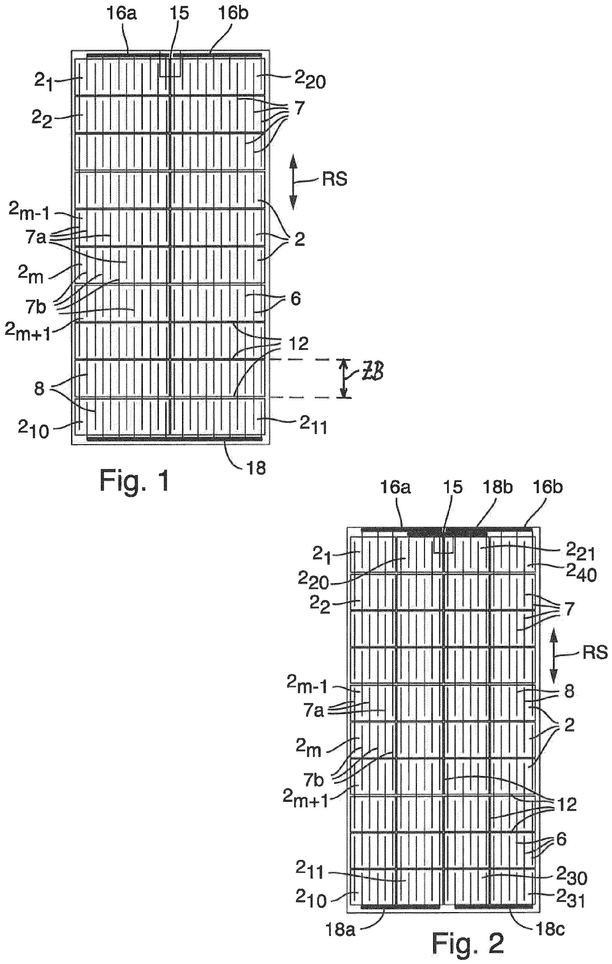

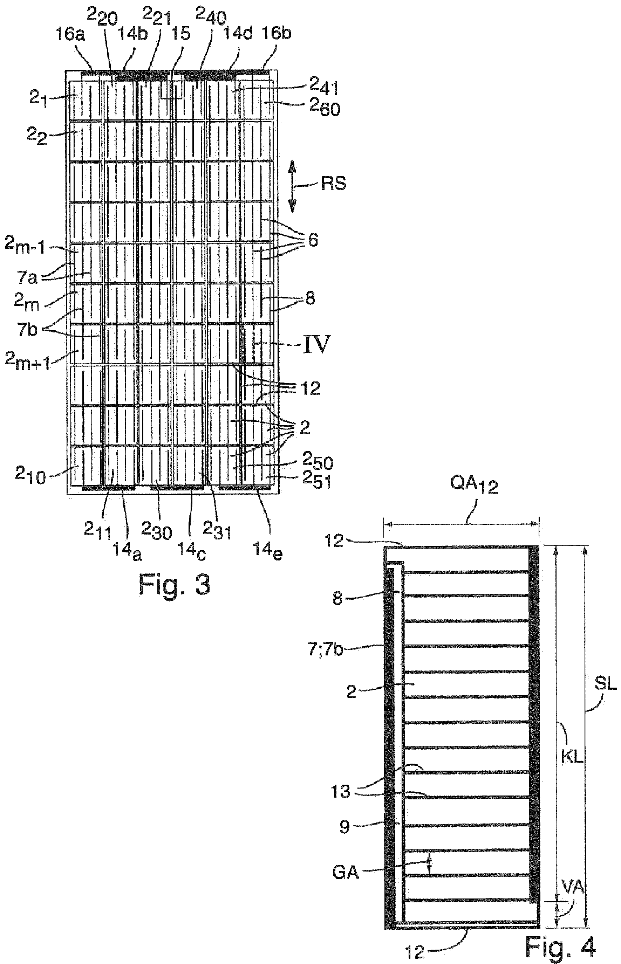

Das monolithische Solarzellenarray 1 ist in an sich bekannter Weise mittels Trennstreifenbereichen 12 in die einzelnen Solarzellen 2 aufgeteilt. Fig. 1 veranschaulicht ein Beispiel, bei dem das Solarzellenarray 1 eine Rechteckform aufweist und in zwei Reihen von jeweils zehn Solarzellen 2₁ bis 2₁₀ bzw. 2₁₁ bis 2₂₀ aufgeteilt ist, wobei die Solarzellen in jeder Reihe in der erwähnten Reihenschaltungsrichtung RS nebeneinander bzw. aufeinanderfolgend angeordnet und elektrisch seriell verbunden sind. Im gezeigten Beispiel haben die Solarzellen 2₁ bis 2₁₀ bzw. 2₁₁ bis 2₂₀ sämtlich eine gleiche Zellenweite bzw. Zellenbreite ZB, d.h. Längsausdehnung in der Reihenschaltungsrichtung RS, wobei die Zellenbreite ZB z.B. im Bereich zwischen 1cm und 30cm liegen kann, insbesondere im Bereich zwischen ca. 2cm und ca. 10cm. Über eine seitliche Sammelschiene 18 sind die beiden Solarzellenreihen miteinander elektrisch seriell verbunden, und auf einer gegenüberliegenden Arrayseite befinden sich in gleichfalls üblicher Weise eine Anschlussdoseneinheit 15 und zwei Anschlussschienen 16a, 16b. Fig. 2 veranschaulicht analog ein Beispiel mit vier seriell geschalteten Reihen von je zehn seriell geschalteten Solarzellen 2₁ bis 2₁₀, 2₁₁ bis 2₂₀, 2₂₁ bis 2₃₀, 2₃₁ bis 2₄₀, wobei in diesem Fall drei seitliche Sammelschienen 18a, 18b, 18c für die serielle Verschaltung der Solarzellenreihen sorgen. Fig. 3 veranschaulicht ein Beispiel mit sechs seriell geschalteten Reihen zu je zehn seriell geschalteten Solarzellen 2₁ bis 2₁₀, ..., 2₅₁ bis 2₆₀ unter Verwendung von dementsprechend fünf Sammelschienen 18a bis 18e zur Serienverschaltung der Solarzellenreihen untereinander. In den gezeigten Beispielen ist das Solarzellenarray 1 rechteckförmig, in alternativen Ausführungen besitzt es eine andere herkömmliche Form. Bei der gezeigten Rechteckform des Solarzellenarrays 1 verlaufen die Trennstreifenbereiche 12 bevorzugt in einem Gittermuster, so dass das Solarzellenarray 1 in Zeilen und Spalten von Solarzellen aufgeteilt ist. Die Reihenschaltungsrichtung RS verläuft dementsprechend in Zeilen- oder Spaltenrichtung.

Die Kontaktstreifen 7 sind quer zur Reihenschaltungsrichtung RS voneinander beabstandet und verlaufen mit einer Richtungskomponente in der Reihenschaltungsrichtung RS in Verbindungsstreifenbereichen 8 der Solarzellen 2. Jeder Kontaktstreifen 7 kontaktiert eine der Absorberschicht 5 zugewandte Seite 3a der Rückkontaktschicht 3 einer der Solarzellen 2 und eine der Absorberschicht 5 abgewandte Seite 4b der Frontkontaktschicht 4 einer benachbarten anderen der Solarzellen 2, wobei die Verbindungsstreifenbereiche 8 der Solarzellen Verbindungsaussparungen 9 in der Frontkontaktschicht 4 und der Absorberschicht 5 zur Freilegung der absorberschichtzugewandten Seite 3a der Rückkontaktschicht 3 aufweisen.

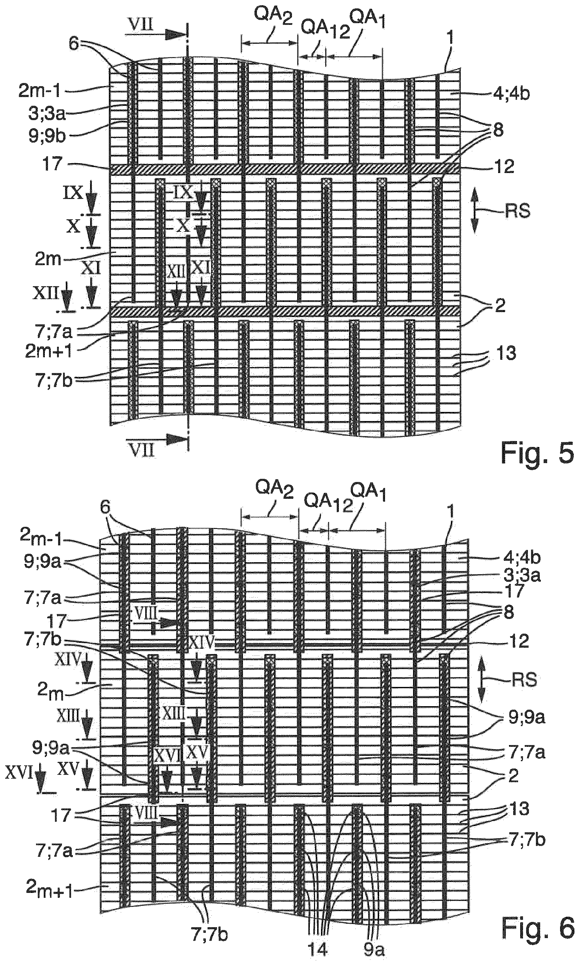

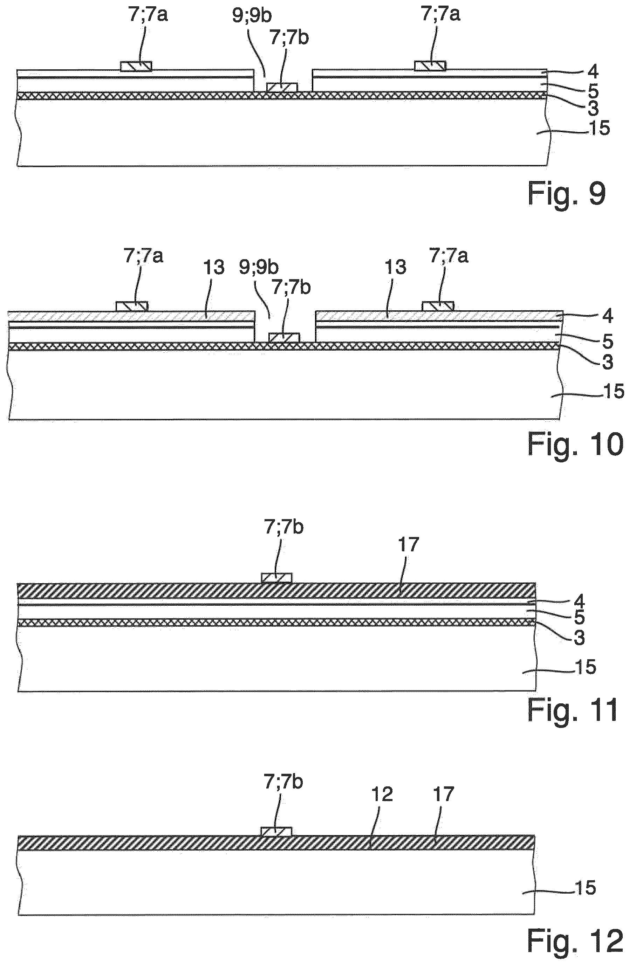

In einer in den Figuren 5, 7 und 9 bis 12 veranschaulichten Ausführung kontaktiert der jeweilige Kontaktstreifen 7 die Rückkontaktschicht 3 der betreffenden Solarzelle 2 entlang seiner Erstreckung über der Rückkontaktschicht 3 durchgehend. Dazu besteht in diesem Fall die jeweilige Verbindungsaussparung 9 aus einem einteilig durchgehenden Verbindungsgraben 9b. Eine Kontaktfläche des jeweiligen Kontaktstreifens 7 zur Rückkontaktschicht 3 besitzt vorzugsweise ein Länge/Breite-Verhältnis von mindestens 3:1, z.B. mindestens 5:1 oder mindestens 10:1 oder mindestens 30:1 oder mindestens 1000:1. Beispielsweise können die Kontaktstreifen 7 eine Länge zwischen ca. 1cm und ca. 20cm und eine Breite zwischen ca. 10µm und 3000µm haben. Der jeweilige Verbindungsgraben 9b kann analog z.B. mit einem Länge/Breite-Verhältnis von mindestens 3:1, bevorzugt mindestens 5:1 oder mindestens 10:1 oder mindestens 30:1 oder mindestens 1000:1, dimensioniert sein.

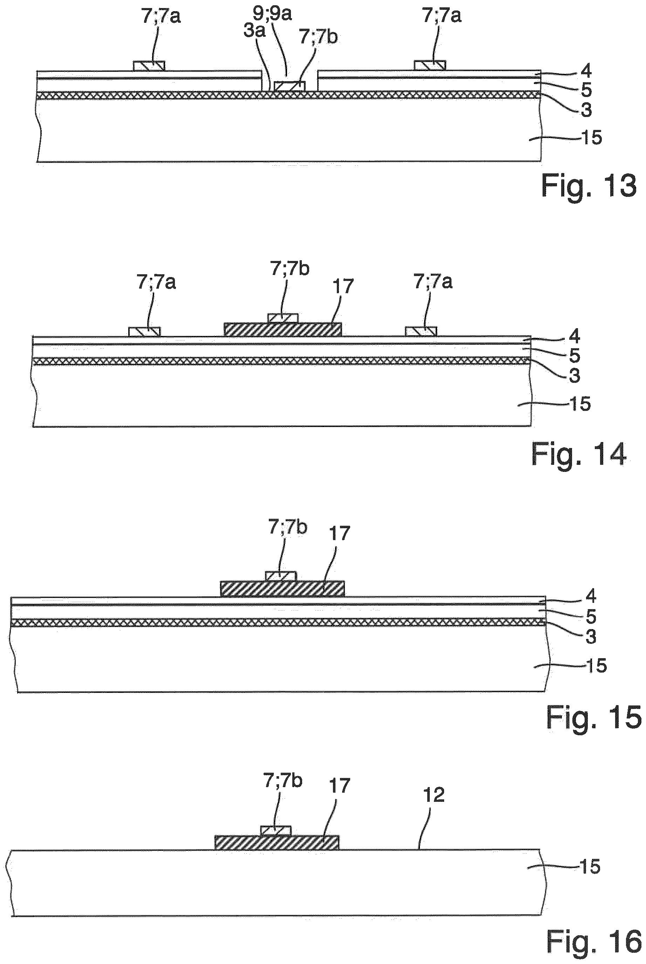

In einer in den Figuren 6, 8 und 13 bis 16 veranschaulichten Ausführung kontaktiert der jeweilige Kontaktstreifen 7 die Rückkontaktschicht 3 der betreffenden Solarzelle 2 entlang seiner Erstreckung über der Rückkontaktschicht 3 in einem oder wie gezeigt mehreren voneinander beabstandeten Kontaktabschnitten 14. Diese Kontaktabschnitte 14 sind durch entsprechende Durchkontaktöffnungen 9a in der Frontkontaktschicht 4 und der Absorberschicht 5 gebildet. In diesem Fall besteht folglich die jeweilige Verbindungsaussparung 9 aus einem oder wie gezeigt mehreren dieser Durchkontaktöffnungen 9a im betreffenden Verbindungsstreifenbereich 8. Auch in diesem Fall kann der jeweilige Kontaktstreifen 7 z.B. eine Länge zwischen ca. 1cm und ca. 30cm und eine Breite zwischen ca. 10µm und ca. 3000µm bzw. ein Länge/Breite-Verhältnis von mindestens ca. 3:1, z.B. mindestens ca. 5:1 oder mindestens ca. 10:1 oder mindestens ca. 30:1 oder mindestens 1000:1 haben.

In entsprechenden Realisierungen weist wie in den gezeigten Beispielen das Solarzellenarray 1 eine Substratschicht 15 auf, auf der die Solarzellen 2 gemeinsam angeordnet sind, wobei sie mit ihrer Rückkontaktschicht 3 der Substratschicht 15 zugewandt sind, speziell mit einer der Absorberschicht 5 abgewandten Seite 3b der Rückkontaktschicht 3. Bei der Substratschicht 15 kann es sich z.B. um ein übliches Glassubstrat, d.h. Glasträger, oder irgendeine andere herkömmliche Unterlage handeln, wie sie der Fachmann zum Tragen des Solarzellen-Dünnschichtaufbaus kennt.

Je zwei nebeneinanderliegende und elektrisch seriell verbundene Solarzellen 2ₘ₋₁ und 2ₘ, 2ₘ und 2ₘ₊₁ etc. sind in ihrem Schichtaufbau durch den Trennstreifenbereich 12 voneinander separiert, und die Kontaktstreifen 7 erstrecken sich zur elektrisch seriellen Verbindung der jeweiligen beiden Solarzellen 2ₘ₋₁, 2ₘ etc. quer über deren Trennstreifenbereich 12 hinweg. Die Trennstreifenbereiche 12 sind in der Ausführung der Fig. 5, 7 und 9 bis 12 durch eine Isolationsschicht 17 aus elektrisch isolierendem Material abgedeckt, damit dort die kreuzenden Kontaktstreifen 7 nicht mit dort ansonsten freiliegenden Seitenflanken der Rückkontaktschicht 3 und der Absorberschicht 5 in Kontakt kommen. Die Isolationsschicht 17 kann durch eine herkömmliche Schichtdepositionstechnik oder als in die bzw. auf die Trennstreifenbereiche 12 ein- bzw. aufgebrachtes Pastenmaterial oder vorgefertigtes Streifen- bzw. Bandmaterial realisiert sein. In Ausführungen, in denen sich wie in den gezeigten Beispielen die Isolationsschicht 17 nicht nur im Trennstreifenbereich 12 selbst erstreckt, sondern zusätzlich in einem angrenzenden Bereich des Schichtaufbaus von Absorberschicht 5 und Frontkontaktschicht 4, ist die Isolationsschicht 17 zweckmäßig aus einem transparenten Material gebildet, d.h. einem Material, das für Licht durchlässig ist, das vorliegend für die photovoltaische Funktion der Solarzellen 2 relevant ist.

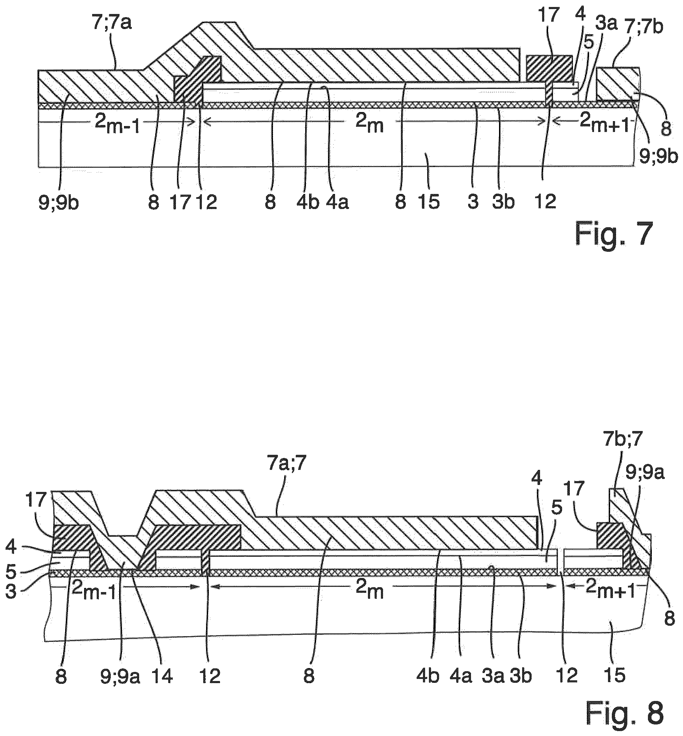

In der Ausführungsvariante, bei welcher der jeweilige Kontaktstreifen 7 die Rücckontaktschicht 3 der Solarzelle 2 nur quasi punktuell in dem einen oder den mehreren voneinander beabstandeten Kontaktabschnitten 14 unter Bildung entsprechender Kontaktflecke bzw. Kontaktpunkte kontaktiert, ist die Isolationsschicht 17 zwischen den Kontaktabschnitten 14 in den Verbindungsstreifenbereichen 8 zwischen der Frontkontaktschicht 4 und dem Kontaktstreifen 7 vorgesehen, um den Kontaktstreifen 7 in diesem Bereich elektrisch von der Frontkontaktschicht 4 isoliert zu halten. Die Isolationsschicht 17 kann wiederum in einem Schichtdepositionsprozess oder alternativ durch ein Pastenmaterial oder ein vorgefertigtes elektrisch isolierendes Streifen- /Bandmaterial bereitgestellt sein. Dabei kann in einer vorteilhaften Fertigungsvariante die Isolationsschicht 17 durchgehend über die Frontkontaktschicht 4 im Verbindungsstreifenbereich 8 der betreffenden Solarzelle 2 aufgebracht bzw. angebracht werden, wonach im Bereich der Kontaktabschnitte 14 Durchkontaktöffnungen 9a in die Isolationsschicht 17 eingebracht werden, wie in Fig. 8 zu erkennen. In jedem Fall ist es in diesem Fall zweckmäßig, für die Isolationsschicht 17 ein lichttransparentes Material zu verwenden, um entsprechende Lichtverluste durch die Isolationsschicht 17 auch in Bereichen zu vermeiden, in denen die Isolationsschicht 17 nicht vom Kontaktstreifen 7 bedeckt ist, z.B. wenn sie sich wie im gezeigten Beispiel im Verbindungsstreifenbereich 8 seitlich jeweils über den aufgebrachten Kontaktstreifen 7 hinaus auf der Frontkontaktschicht 4 erstreckt.

In entsprechenden Ausführungen sind die Kontaktstreifen 7 getrennt vom monolithischen Solarzellenarray 1 gefertigte Bauteile, die am monolithischen Solarzellenarray 1 angebracht werden. Hierfür können die Kontaktstreifen 7 z.B. als entsprechende Kontaktdrähte oder Kontaktbänder vorgefertigt sein, wie bereits oben erwähnt. Alternativ sind die Kontaktstreifen 7 durch einen Siebdruckprozess aus einem geeigneten, elektrisch leitenden Pastenmaterial mit anschließendem Trocknungs- bzw. Feuerungsprozess oder durch einen Schichtdepositionsprozess gebildet, bei dem ein entsprechendes, elektrisch leitendes Material als Schicht aufgebracht wird, wonach diese Schicht in die Kontaktstreifen 7 strukturiert wird, z.B. durch übliche Photolithographie- und Ätzprozesse. Für die Kontaktstreifen 7 sind zahlreiche, vorzugsweise metallische Materialien geeignet, wie Kupfer (Cu), z.B. als optional verzinntes Bandmaterial, Silber (Ag), Gold (Au), Aluminium (Al), Nickel (Ni) und Legierungen aus mehreren dieser und/oder anderer Metalle.

In vorteilhaften Ausführungsformen grenzen wie in den gezeigten Beispielen eine erste Solarzelle 2ₘ₋₁ und eine dritte Solarzelle 2ₘ₊₁ auf gegenüberliegenden Seiten an eine zweite Solarzelle 2ₘ an, wobei die erste Solarzelle 2ₘ₋₁ und die zweite Solarzelle 2ₘ durch einen oder alternativ wie gezeigt mehrere erste Kontaktstreifen 7a elektrisch seriell verbunden sind und die zweite Solarzelle 2ₘ und die dritte Solarzelle 2ₘ₊₁ durch einen oder wie gezeigt mehrere zweite Kontaktstreifen 7b elektrisch seriell verbunden sind. Jeder erste Kontaktstreifen 7a kontaktiert die der Absorberschicht 5 zugewandte Seite 3a der Rückkontaktschicht 3 der ersten Solarzelle 2ₘ₋₁ und die der Absorberschicht 5 abgewandte Seite 4b der Frontkontaktschicht 4 der zweiten Solarzelle 2ₘ. Jeder zweite Kontaktstreifen 7b kontaktiert die der Absorberschicht 5 zugewandte Seite 3a der Rückkontaktschicht 3 der zweiten Solarzelle 2ₘ und die der Absorberschicht 5 abgewandte Seite 4b der Frontkontaktschicht 4 der dritten Solarzelle 2ₘ₊₁. Im Bereich der zweiten Solarzelle 2ₘ erstrecken sich mindestens ein erster Kontaktstreifen 7a und einer zweiter Kontaktstreifen 7b derart, dass sie in Richtung quer zur Reihenschaltungsrichtung RS überlappen. Durch diese überlappende Erstreckung ergibt sich eine ineinandergreifende Struktur der ersten Kontaktstreifen 7a einerseits und der zweiten Kontaktstreifen 7b andererseits auf jeder Solarzelle 2, wie insbesondere aus den Figuren 1 bis 3, 5 und 6 ersichtlich. Dies ermöglicht eine optimale Erfassung der Flächenausdehnung der Solarzellen 2 durch die Kontaktstreifen 7. Dadurch können an beliebiger Stelle in der Absorberschicht 5 der Solarzellen 2 generierte elektrische Ladungen auf relativ kurzem Weg zur Frontkontaktschicht 4 bzw. Rückkontaktschicht 3 und von dort zu den Kontaktstreifen 7 gelangen.

In alternativen Ausführungen grenzen eine erste und eine dritte Solarzelle nicht auf gegenüberliegenden Seiten an eine zweite Solarzelle an, sondern z.B. an zwei benachbarten Seiten der zweiten Solarzelle. In diesem Fall unterscheiden sich dann die Reihenschaltungsrichtungen für die elektrisch serielle Verschaltung der ersten und der zweiten Solarzelle einerseits sowie der zweiten und dritten Solarzelle andererseits. Beispielsweise können diese beiden Reihenschaltungsrichtungen dann senkrecht zueinander verlaufen oder unter einem spitzen Winkel schräg zueinander.

In entsprechenden Ausführungen sind wie in den gezeigten Beispielen im Bereich einer jeweiligen Solarzelle 2 die ersten Kontaktstreifen 7a mit gleichem Querabstand QA₁ voneinander angeordnet. In vorteilhaften Realisierungen beträgt der Querabstand QA1 der ersten Kontaktstreifen 7a voneinander zwischen 10mm und 100mm. In alternativen Ausführungen können die ersten Kontaktstreifen 7a mit unterschiedlichen Querabständen angeordnet sein.

In entsprechenden Ausführungen sind wie in den gezeigten Beispielen die zweiten Kontaktstreifen 7b mit gleichem Querabstand QA₂ voneinander angeordnet. In vorteilhaften Realisierungen beträgt der Querabstand QA₂ der zweiten Kontaktstreifen 7b voneinander zwischen 10mm und 100mm. In alternativen Ausführungen können sie mit verschiedenen Querabständen angeordnet sein.

In entsprechenden Ausführungen sind wie in den gezeigten Beispielen die ersten Kontaktstreifen 7a und die zweiten Kontaktstreifen 7b alternierend mit gleichem Querabstand QA₁₂ voneinander angeordnet. In vorteilhaften Realisierungen beträgt der Querabstand QA₁₂ der ersten und zweiten Kontaktstreifen 7a, 7b voneinander zwischen 5mm und 50mm. In alternativen Ausführungen können sie mit unterschiedlichen Querabständen und/oder in einer nicht-alternierenden Abfolge in Querrichtung angeordnet sein.

In vorteilhaften Ausführungen erstrecken sich die Kontaktstreifen 7 wie in den gezeigten Beispielen im Bereich einer jeweiligen Solarzelle 2 mit einer in Fig. 4 markierten Streifenlänge KL, die mindestens 50% der Längenausdehnung SL der Solarzelle 2 in der Erstreckungsrichtung der Kontaktstreifen 7, d.h. der Zellenweite ZB, beträgt. Bevorzugt beträgt die Streifenlänge KL der Kontaktstreifen mindestens 80% der Längenausdehnung SL der Solarzelle 2. In der Variante mit durchgehender Rückkontaktschichtkontaktierung im jeweiligen Verbindungsgraben 9b gilt gleiches für die Längenerstreckung des Verbindungsgrabens 9b bzw. für die durchgehende Kontaktfläche des Kontaktstreifens 7 mit der Rückkontaktschicht 3. Dabei kann auch vorgesehen sein, die Kontaktstreifen 7 bzw. den Verbindungsgraben 9b jeweils mit einem vorgebbaren Abstand im Bereich von z.B. 1mm bis 15mm zu der benachbarten Solarzelle bzw. zu dem betreffenden Trennstreifenbereich 12 enden zu lassen. In entsprechenden Ausführungen beträgt die Zellenweite ZB, d.h. die Längenausdehnung SL der jeweiligen Solarzelle 2 in der Erstreckungsrichtung der Kontaktstreifen 7, zwischen 10mm und 300mm.

In vorteilhaften Realisierungen erstrecken sich die Kontaktstreifen 7 im Bereich einer jeweiligen Solarzelle 2 zumindest mit ihrem die Frontkontaktschicht 4 kontaktierenden Streifenabschnitt mit einer Streifenlänge KL, die gegenüber der Längenausdehnung SL der Solarzelle 2, d.h. der Zellenweite ZB, um einen Verkürzungsabstand VA geringer ist, der höchstens doppelt so groß ist wie ein Gridabstand GA einer Kontaktgridstruktur 13, mit der die Frontkontaktschicht 4 wie in den gezeigten Beispielen optional in an sich herkömmlicher Weise versehen ist. Dabei können die Kontaktstreifen 7 über der bereits gebildeten Kontaktgridstruktur 13 angebracht werden. Alternativ können zunächst die Kontaktstreifen 7 angebracht werden, bevor danach die Kontaktgridstruktur 13 gebildet wird.

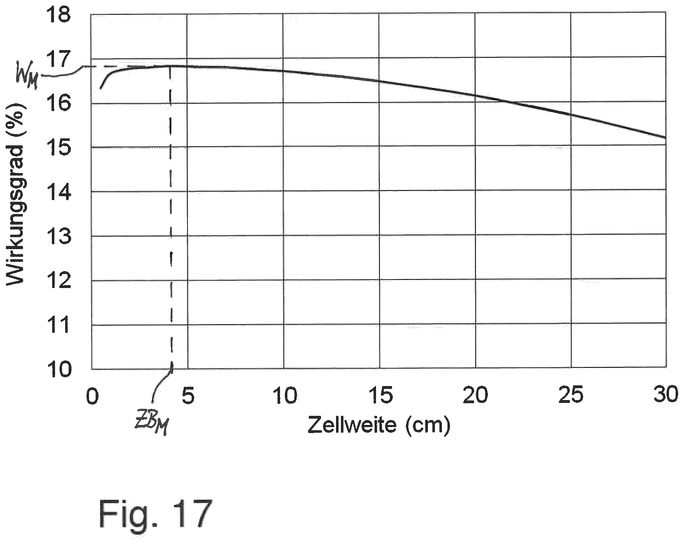

Fig. 17 zeigt für ein typisches, exemplarisches Moduldesign den ermittelten funktionellen Verlauf des Wirkungsgrades der photoelektrischen Umwandlung für das Dünnschichtsolarmodul bei variierter Zellenbreite bzw. Zellenweite in Diagrammform, wobei die Zellenweite verkürzt als Zellweite in Fig. 17 bezeichnet ist. Die Ermittlung dieses Verlaufs bzw. dieser Kennlinie lässt sich sowohl durch rechnerische Simulation als auch durch eine entsprechende experimentelle Versuchsreihe verifizieren, wobei als Wirkungsgrad der wie üblich unter sog. STC-Bedingungen ermittelte Wirkungsgrad zu verstehen ist. Es versteht sich, dass der diagrammatisch für ein spezielles erfindungsgemäßes Moduldesign wiedergegebene Verlauf des Wirkungsgrades, wie üblich angegeben in Prozent, als Funktion der Zellenweite, angegeben in Zentimeter, unter Konstanthaltung der übrigen Modulparameter ermittelt wurde.

Abgesehen von der charakteristischen Serienverschaltungsstruktur liegen diesem Moduldesign übliche Modulparameter zugrunde. So wurde für die Rückkontaktschicht 3 ein Molybdän-Material, für die Frontkontaktschicht 4 ein Zinkoxid-Material und für die Absorberschicht 5 ein CIGS-Material gewählt. Die elektrischen Schichtwiderstände betrugen für die Molybdän-Rückkontaktschicht 0,6Ω/sq und für die ZnO-Frontkontaktschicht 75Ω/sq. Des Weiteren kam eine Kontaktfingerstruktur mit einer Fingerbreite von 0,0073cm und einem Fingerabstand von 0,15cm zum Einsatz. Für die charakteristische Kontaktstreifenstruktur wurde eine Breite und eine Dicke des jeweiligen Kontaktstreifens 7 von jeweils 0,03cm gewählt, wobei die Längserstreckung der Kontaktstreifen 7 an die Veränderung der Zellenbreite ZB derart angepasst wurde, dass ein Abstand des jeweiligen Kontaktstreifens 7 an jedem seiner beiden Enden zum benachbarten Trennbereich 12 konstant bleibt, z.B. ein gleichbleibender Abstand des Kontaktstreifens 7 zum benachbarten Trennbereich 12 von jeweils ca. 2mm an beiden Enden des Kontaktstreifens 7. Das Länge/Breite-Verhältnis des jeweiligen Verbindungsgrabens 9b bzw. der Kontaktfläche des jeweiligen Kontaktstreifens 7 zur Rückkontaktschicht 3 liegt damit im Fall einer Zellenweite zwischen 0,5cm und 30cm im Bereich zwischen ca. 15:1 und ca. 1.000:1.

Wie aus Fig. 17 ersichtlich, ergibt sich für dieses Moduldesign ein Maximum W_{M} des Wirkungsgrades von etwas mehr als 16,8% bei einer Zellenweite ZB_{M} von ca. 4cm. Dieses Resultat ist insofern bemerkenswert, als das Wirkungsgradmaximum von herkömmlichen Moduldesigns bei deutlich niedrigerer Zellenweite liegt, typischerweise im Bereich von Zellenweiten zwischen 0,1cm und 1,5cm.

Ein weiteres, aus Fig. 17 ersichtliches Resultat ist der vergleichsweise flache Verlauf der Kennlinie für den Wirkungsgrad bei variierter Zellenweite. So ergibt sich einerseits bei einer Zellenweite ZB von ca. 0,7cm und andererseits vor allem auch bei einer relativ großen Zellenweite ZB von ca. 15cm jeweils noch ein Wirkungsgrad von ca. 16,5%, was einer Verringerung gegenüber dem Wirkungsgradmaximum W_{M} von absolut nur ca. 0,3% und relativ nur knapp 2% des Maximalwerts W_{M} entspricht. Dies kontrastiert signifikant mit herkömmlichen Moduldesigns, die lediglich mit zellenrandseitigen Serienverbindungsstrukturen oder mit allenfalls kurzen Kontaktstreifen arbeiten. Diese Moduldesigns können zwar ein ähnlich großes Wirkungsgradmaximum haben, wie erwähnt üblicherweise bei deutlich geringeren Zellenweiten unterhalb 1,5cm, jedoch ergibt sich ein viel stärkerer Abfall des Wirkungsgrades ausgehend von diesem Maximum insbesondere in Richtung größerer Zellenweite.

So ergibt sich z.B. für ein zum Vergleich herangezogenes Moduldesign mit herkömmlicher P1-P2-P3-Strukturierung anstelle der erfindungsgemäßen Kontaktstreifenstruktur bei ansonsten gleichen Modulparametern ein vergleichbar großer maximaler Wirkungsgrad, allerdings für eine Zellenbreite ZB von ca. 0,6cm, und der Wirkungsgrad fällt mit größerer Zellenweite ZB rasch ab und erreicht bei einer Zellenweite ZB von 4 cm nur noch einen Wert von ca. 10%. Für ein weiteres Vergleichsbeispiel mit kurzen Kontaktstreifen, die sich nur geringfügig z.B. über eine Länge von höchstens ca. 8mm vom Trennstreifenbereich aus zur jeweiligen Solarzelle erstrecken, ergibt sich für ansonsten gleiche Modulparameter ein Wirkungsgradmaximum von ca. 16% für eine Zellenweite ZB von ca. 3cm mit einem wiederum relativ steilen Wirkungsgradabfall mit größerer Zellenweite ZB auf einen Wert von weniger als 5% absolut für eine Zellenweite ZB von 15 cm.

Es sei an dieser Stelle erwähnt, dass sich im betrachteten Beispiel von Fig. 17 selbst für eine Zellenweite von 30cm noch ein Wirkungsgrad von etwas mehr als 15% ergibt, der folglich absolut gesehen immer noch lediglich ca. 1,7% unter dem Maximalwert liegt, d.h. relativ gesehen um nur 10% unter dem Maximalwert. Dies zeigt somit deutlich die Vorteile der erfindungsgemäßen elektrischen Verbindungsstruktur mit den charakteristischen Kontaktstreifen 7, wenn diese sich über einen wesentlichen Teil der Zellenweite ZB der Solarzellen hinweg erstrecken.

Für das Beispiel von Fig. 17 wurde ein Moduldesign in derjenigen Variante gewählt, bei welcher der jeweilige Kontaktstreifen 7 die Rückkontaktschicht 3 der betreffenden Solarzelle 2 entlang seiner Erstreckung durchgehend kontaktiert und dazu in den zugehörigen Verbindungsgraben 9b eingebracht ist. Jedoch zeigt sich, dass die Variante mit punktueller Kontaktierung der Rückkontaktschicht 3 über die zugehörigen Durchkontaktöffnungen 9a bei gleicher Länge der Kontaktstreifen 7 im Wesentlichen die gleichen Eigenschaften bezüglich des Wirkungsgrades in Abhängigkeit von der Zellenweite ZB aufweist, d.h. ein Wirkungsgradmaximum bei einer relativ großen Zellenweite ZB von mehr als 2cm und einen relativ flachen Verlauf der Kennlinie insbesondere auch zur Seite größer werdender Zellenweite ZB hin.

Wie die gezeigten und die weiteren oben erläuterten Ausführungsbeispiele deutlich machen, stellt die Erfindung ein Dünnschichtsolarmodul zur Verfügung, das sich mit relativ geringem Aufwand herstellen lässt und die Erzielung eines hohen Solarmodulwirkungsgrades ermöglicht, wobei sich insbesondere auch die Stromtransportverluste vergleichsweise niedrig halten lassen. Dazu trägt wesentlich die spezifische elektrische Verbindungsstruktur unter Verwendung der speziellen Kontaktstreifen bei.

Die Kontaktierung der Frontkontaktschicht erfolgt über die Kontaktstreifen, optional unterstützt durch eine herkömmliche frontseitige Kontaktgridstruktur. Die Rückkontaktschicht wird von der Frontseite her, d.h. an ihrer der Absorberschicht zugewandten Seite, freigelegt, wozu die Absorberschicht entsprechend strukturiert gebildet bzw. entfernt wird, und mittels der Kontaktstreifen kontaktiert. Bei ineinandergreifender Anordnung der Kontaktstreifen lässt sich die Länge der Strompfade sehr gering halten, was dementsprechend die ohmschen Widerstandsverluste gering hält.

Die Erfindung ermöglicht bzw. erleichtert auf diese Weise die Herstellung relativ großflächiger Solarzellen mit geringen Flächenverlusten und niedrigen Modulspannungen ohne unerwünschte elektrische Verluste durch lange Strompfade innerhalb der Frontkontaktschicht und der Rückkontaktschicht. Durch die Kontaktierung der Frontkontaktschicht und der Rückkontaktschicht über praktisch die gesamte Längserstreckung oder jedenfalls über einen großen Teil der Längserstreckung der Solarzellen werden zudem elektrische Verluste bei der Stromauskopplung und der Stromeinkopplung minimiert.

## Patentansprüche

1. Dünnschichtsolarmodul mit
- einem monolithischen Solarzellenarray (1), das eine Mehrzahl von Solarzellen (2) mit einem Schichtaufbau beinhaltet, der eine Rückkontaktschicht (3), eine Frontkontaktschicht (4) und eine Absorberschicht (5) zwischen der Rücckontaktschicht und der Frontkontaktschicht umfasst, und
- einer elektrischen Verbindungsstruktur (6) mit Kontaktstreifen (7) zur elektrisch seriellen Verbindung nebeneinander angeordneter Solarzellen, wobei die elektrische Verbindungsstruktur je zwei in einer Reihenschaltungsrichtung (RS) aneinandergrenzende Solarzellen (2ₘ, 2ₘ₊₁) durch einen oder mehrere Kontaktstreifen (7) miteinander elektrisch seriell verbindet,
- wobei die Kontaktstreifen quer zur Reihenschaltungsrichtung voneinander beabstandet mit einer Richtungskomponente in der Reihenschaltungsrichtung in Verbindungsstreifenbereichen (8) der Solarzellen verlaufen und jeder Kontaktstreifen eine absorberschichtzugewandte Seite (3a) der Rückkontaktschicht der einen Solarzelle und eine absorberschichtabgewandte Seite (4b) der Frontkontaktschicht der anderen Solarzelle kontaktiert, wobei die Verbindungsstreifenbereiche der Solarzellen Verbindungsaussparungen (9) in der Frontkontaktschicht und der Absorberschicht zur Freilegung der absorberschichtzugewandten Seite der Rückkontaktschicht aufweisen, und
- wobei der jeweilige Kontaktstreifen im Verbindungsstreifenbereich in einem die Verbindungsaussparung bildenden Verbindungsgraben (9b) der betreffenden Solarzelle verläuft und die Rückkontaktschicht der betreffenden Solarzelle entlang seiner Erstreckung über der Rückkontaktschicht durchgehend kontaktiert und sich zwischen den zugeordneten Solarzellen über einen diese separierenden Trennstreifenbereich (12) hinweg unter Zwischenfügung einer Isolationsschicht (17) erstreckt,
**dadurch gekennzeichnet, dass**
eine Kontaktfläche des jeweiligen Kontaktstreifens zur Rückkontaktschicht ein Länge/Breite-Verhältnis von mindestens 3:1 besitzt.

2. Dünnschichtsolarmodul nach Anspruch 1, wobei
- eine Zellenweite (ZB) der jeweiligen Solarzelle in der Reihenschaltungsrichtung mindestens 2cm beträgt, insbesondere mindestens 3cm, und
- der Wirkungsgrad des Dünnschichtsolarmoduls mindestens 14%, insbesondere mindestens 16%, beträgt und/oder ein Maximum des Wirkungsgrades des Dünnschichtsolarmoduls als Funktion einer Zellenweite (ZB) der jeweiligen Solarzelle in der Reihenschaltungsrichtung in einem Bereich der Zellenweite zwischen 2cm und 10cm liegt und/oder der Wirkungsgrad des Dünnschichtsolarmoduls als Funktion einer Zellenweite (ZB) der jeweiligen Solarzelle in der Reihenschaltungsrichtung im Bereich der Zellenweite zwischen 2cm und 20cm um relativ höchstens 20%, insbesondere um relativ höchstens 10%, schwankt.

3. Dünnschichtsolarmodul nach Anspruch 1 oder 2, wobei eine erste (2ₘ₋₁) und eine dritte Solarzelle (2ₘ₊₁) auf gegenüberliegenden Seiten an eine zweite Solarzelle (2ₘ) angrenzen, wobei die erste und die zweite Solarzelle durch einen oder mehrere erste Kontaktstreifen (7a) elektrisch seriell verbunden sind und die zweite und die dritte Solarzelle durch einen oder mehrere zweite Kontaktstreifen (7b) elektrisch seriell verbunden sind und jeder der ersten Kontaktstreifen die absorberschichtzugewandte Seite der Rückkontaktschicht der ersten Solarzelle und die absorberschichtabgewandte Seite der Frontkontaktschicht der zweiten Solarzelle kontaktiert und jeder der zweiten Kontaktstreifen die absorberschichtzugewandte Seite der Rückkontaktschicht der zweiten Solarzelle und die absorberschichtabgewandte Seite der Frontkontaktschicht der dritten Solarzelle kontaktiert und wobei sich im Bereich der zweiten Solarzelle mindestens ein erster und ein zweiter Kontaktstreifen in Richtung quer zur Reihenschaltungsrichtung überlappend erstrecken.

4. Dünnschichtsolarmodul nach Anspruch 3, wobei im Bereich einer jeweiligen Solarzelle die ersten Kontaktstreifen mit gleichem Querabstand (QA₁) voneinander angeordnet sind und/oder die zweiten Kontaktstreifen mit gleichem Querabstand (QA₂) voneinander angeordnet sind und/oder die ersten und die zweiten Kontaktstreifen alternierend mit gleichem Querabstand (QA₁₂) voneinander angeordnet sind.

5. Dünnschichtsolarmodul nach Anspruch 4, wobei
- der Querabstand der ersten Kontaktstreifen voneinander zwischen 10mm und 100mm beträgt und/oder
- der Querabstand der zweiten Kontaktstreifen voneinander zwischen 10mm und 100mm beträgt und/oder
- der Querabstand der ersten und zweiten Kontaktstreifen voneinander zwischen 5mm und 50mm beträgt.

6. Dünnschichtsolarmodul nach einem der Ansprüche 1 bis 5, wobei das Solarzellenarray eine Substratschicht (15) aufweist, auf der die Solarzellen mit ihrer Rückkontaktschicht der Substratschicht zugewandt gemeinsam angeordnet sind, wobei je zwei nebeneinanderliegende und elektrisch seriell verbundene Solarzellen in ihrem Schichtaufbau durch einen Trennstreifenbereich (12) voneinander separiert sind und sich die Kontaktstreifen zur elektrisch seriellen Verbindung der beiden Solarzellen über deren Trennstreifenbereich hinweg erstrecken.

7. Dünnschichtsolarmodul nach einem der Ansprüche 1 bis 6, wobei die Kontaktstreifen getrennt vom monolithischen Solarzellenarray als Draht- oder Bandmaterial vorgefertigte und am monolithischen Solarzellenarray angebrachte Bauteile sind.

8. Dünnschichtsolarmodul nach einem der Ansprüche 1 bis 7, wobei
- sich die Kontaktstreifen im Bereich einer jeweiligen Solarzelle mit einer Streifenlänge (KL) erstrecken, die mindestens 50%, insbesondere mindestens 80%, der Längenausdehnung (SL) der Solarzelle in der Erstreckungsrichtung der Kontaktstreifen beträgt, und/oder
- sich die Kontaktstreifen im Bereich einer jeweiligen Solarzelle mit ihrem die Frontkontaktschicht kontaktierenden Streifenabschnitt mit einer Streifenlänge (KL) erstrecken, die gegenüber der Längenausdehnung (SL) der Solarzelle in der Erstreckungsrichtung der Kontaktstreifen um einen Verkürzungsabstand (VA) geringer ist, der höchstens doppelt so groß, insbesondere höchstens so groß, ist wie ein Gridabstand (GA) einer Kontaktgridstruktur (13) der Frontkontaktschicht.

9. Dünnschichtsolarmodul nach Anspruch 8, wobei die Längenausdehnung der jeweiligen Solarzelle in der Erstreckungsrichtung der Kontaktstreifen zwischen 10mm und 300mm beträgt.

10. Dünnschichtsolarmodul nach einem der Ansprüche 1 bis 9, wobei das Länge/Breite-Verhältnis der Kontaktfläche des jeweiligen Kontaktstreifens zur Rückkontaktschicht im Bereich zwischen 15:1 und 1000:1 liegt, wenn eine Zellenweite (ZB) der Solarzelle zwischen 0,5 cm und 30 cm beträgt.

11. Verfahren zur Herstellung eines Dünnschichtsolarmoduls nach einem der Ansprüche 1 bis 10, mit folgenden Schritten:
- Vorfertigen des monolithischen Solarzellenarrays (1),
- Bilden der Verbindungsaussparungen (9),
- Anbringen der Kontaktstreifen (7) in den Verbindungsstreifenbereichen (8) unter elektrischem Kontaktieren mit der Rückkontaktschicht (3) in den Verbindungsaussparungen und mit der Frontkontaktschicht (4) der jeweils zugehörigen Solarzellen und
- Fertigstellen des Dünnschichtsolarmoduls.

12. Verfahren nach Anspruch 11, wobei vor dem Anbringen der Kontaktstreifen (7) die Isolationsschicht (17) in den Verbindungsstreifenbereichen (8) auf der Frontkontaktschicht (4) und/oder in den Trennstreifenbereichen (12) aufgebracht wird.

13. Verfahren nach Anspruch 11 oder 12, wobei die Kontaktstreifen (7) getrennt vom monolithischen Solarzellenarray vorgefertigt und am monolithischen Solarzellenarray angebracht werden.

## Claims

1. Thin film solar module having
a monolithic solar cell array (1), which includes a plurality of solar cells (2) having a layered structure that has a rear contact layer (3), a front contact layer (4), and an absorber layer (5) between the rear contact layer and the front contact layer, and
an electrical connection structure (6) having contact strips (7) for electrically connecting in series solar cells arranged adjacent to one another, wherein the electrical connection structure electrically connects in series each two solar cells (2ₘ , 2ₘ₊₁) adjoining in a series connection direction by one or more contact strips (7),
wherein the contact strips are spaced apart from one another transversely to the series connection direction and extend with a directional component in the series connection direction in connecting strip regions (8) of the solar cells and each contact strip contacts a side (3a) of the rear contact layer of one of the solar cells facing toward the absorber layer and a side (4b) of the front contact layer of the other solar cell facing away from the absorber layer, wherein the connecting strip regions of the solar cells have connecting recesses (9) in the front contact layer and the absorber layer to expose the side of the rear contact layer facing toward the absorber layer, and
wherein the respective contact strip extends in the connecting strip region in a connecting trench of the other solar cell that forms the connecting opening and contacts the rear contact layer of the relevant solar cell continuously along its extension over the rear contact layer and extends between the associated solar cells over a separating strip region (12) separating them, with an insulating layer (17) interposed,
**characterized in that**
a contact surface of the respective contact strip to the rear contact layer has a length/width ratio of at least 3:1.

2. Thin film solar module of claim 1, wherein
a cell width (ZB) of the respective solar cell in the series connection direction is at least 2 cm, preferably at least 3 cm, and
the efficiency of the thin film solar module is at least 14%, preferably at least 16%, and/or a maximum of the efficiency of the thin film solar module as a function of a cell width of the respective solar cell in the series connection direction is in a range of the cell width (ZB) between 2 cm and 10 cm, and/or the efficiency of the thin film solar module as a function of the cell width (ZB) of the respective solar cell in the series connection direction varies in the range of the cell width between 2 cm and 20 cm by at most 20%, preferably at most 10%, in relative terms.

3. Thin film solar module of claim 1 or 2, wherein a first (2_{m -1}) and a third solar cell (2_{m +1}) adjoin a second solar cell (2ₘ) on opposite sides, wherein the first and the second solar cell are electrically serially connected by one or more first contact strips (7a) and the second and the third solar cell are electrically serially connected by one or more second contact strips (7b) and each of the first contact strips contacts the side of the rear contact layer of the first solar cell facing toward the absorber layer and the side of the front contact layer of the second solar cell facing away from the absorber layer, and each of the second contact strips contacts the side of the rear contact layer of the second solar cell facing toward the absorber layer and the side of the front contact layer of the third solar cell facing away from the absorber layer, and wherein, in the region of the second solar cell, at least one first and one second contact strip extend overlapping in the direction transverse to the series connection direction.

4. Thin film solar module of claim 3, wherein, in the region of a respective solar cell, the first contact strips are arranged at equal transverse distance (QA₁) from one another and/or the second contact strips are arranged at equal transverse distance (QA₂) from one another and/or the first and the second contact strips are arranged alternating at equal transverse distance (QA₁₂) from one another.

5. Thin film solar module of claim 4, wherein
the transverse distance of the first contact strips from one another is between 10 mm and 100 mm, and/or
the transverse distance of the second contact strips from one another is between 10 mm and 100 mm, and/or
the transverse distance of the first and second contact strips from one another is between 5 mm and 50 mm.

6. Thin film solar module of any of claims 1 to 5, wherein the solar cell array has a substrate layer (15) on which the solar cells are arranged jointly with their rear contact layer facing toward the substrate layer, wherein each two adjacent and electrically serially connected solar cells are separated from one another in their layer structure by a separating strip region (12) and the contact strips extend beyond their separating strip region for the electrical series connection of the two solar cells.

7. Thin film solar module of any of claims 1 to 6, wherein the contact strips are components that are prefabricated separately from the monolithic solar cell array as wire or tape material and attached to the monolithic solar cell array.

8. Thin film solar module of any of claims 1 to 7, wherein
the contact strips extend in the region of a respective solar cell with a strip length that is at least 50%, preferably at least 80%, of the longitudinal extension (SL) of the solar cell in the extension direction of the contact strips, and/or
the contact strips extend in the region of a respective solar cell with their strip section contacting the front contact layer with a strip length (KL) that is less than the longitudinal extension (SL) of the solar cell in the extension direction of the contact strips by a shortening distance (VA) that is at most twice as large, preferably at most as large, as a grid spacing (GA) of a contact grid structure (13) of the front contact layer.

9. Thin film solar module of claim 8, wherein the longitudinal extension of the respective solar cell in the extension direction of the contact strips is between 10 mm and 300 mm.

10. Thin film solar module of any of claims 1 to 9, wherein the length/width ratio of the contact surface of the respective contact strip to the rear contact layer is in the range of 15:1 to 1000:1 if a cell width (ZB) of the solar cell is between 0.5 cm and 30 cm.

11. Method for producing a thin film solar module according to any of claims 1 to 10, comprising the following steps:
prefabricating the monolithic solar cell array (1),
forming the connecting recesses (9),
attaching the contact strips (7) in the connecting strip regions (8) with electrical contacting with the rear contact layer (3) in the connecting recesses and with the front contact layer (4) of the respective associated solar cells, and
completing the thin film solar module.

12. Method of claim 11, wherein the insulating layer (17) is applied in the connecting strip regions (8) on the front contact layer (4) and/or in the separating strip regions (12) before the contact strips (7) are attached.

13. Method of claim 11 or 12, wherein the contact strips (7) are prefabricated separate from the monolithic solar cell array and attached to the monolithic solar cell array.

## Revendications

1. Module solaire à couches minces, comprenant
- un réseau de cellules solaires monolithique (1) qui comporte une pluralité de cellules solaires (2) avec une structure en couches qui comprend une couche à contact arrière (3), une couche à contact avant (4) et une couche absorbante (5) entre la couche à contact arrière et la couche à contact avant, et
- une structure de raccordement électrique (6) avec des bandes de contact (7) pour le raccordement série électrique de cellules solaires disposées les unes à côté des autres, dans lequel la structure de raccordement électrique raccorde électriquement en série l'une à l'autre respectivement deux cellules solaires (2ₘ, 2ₘ₊₁) adjacentes dans une direction de connexion série (RS) par une ou plusieurs bandes de contact (7),
- dans lequel les bandes de contact s'étendent transversalement à la direction de connexion série à distance les unes des autres avec une composante directionnelle dans la direction de connexion série dans des zones de bandes de raccordement (8) des cellules solaires, et chaque bande de contact met en contact une face (3a), tournée vers la couche absorbante, de la couche à contact arrière de ladite une cellule solaire et une face (4b), détournée de la couche absorbante, de la couche à contact avant de l'autre cellule solaire, dans lequel les zones de bandes de raccordement des cellules solaires présentent des évidements de raccordement (9) dans la couche à contact avant et la couche absorbante pour exposer la face, tournée vers la couche absorbante, de la couche à contact arrière, et
- dans lequel la bande de contact respective s'étend dans la zone de bande de contact dans une tranchée de raccordement (9b), formant l'évidement de raccordement, de la cellule solaire concernée, et met en contact continu la couche à contact arrière de la cellule solaire concernée le long de son étendue sur la couche à contact arrière et s'étend entre les cellules solaires associées au-delà d'une zone de bande séparatrice de séparation (12) en intercalant une couche isolante (17),
**caractérisé en ce qu'**une surface de contact de la bande de contact respective possède un rapport longueur/largeur d'au moins 3:1 par rapport à la couche à contact arrière.

2. Module solaire à couches minces selon la revendication 1, dans lequel
- une largeur de cellule (ZB) de la cellule solaire respective dans la direction de connexion série mesure au moins 2 cm, en particulier au moins 3 cm, et
- le rendement du module solaire à couches minces est d'au moins 14 %, en particulier d'au moins 16 %, et/ou un maximum du rendement du module solaire à couches minces en fonction d'une largeur de cellule (ZB) de la cellule solaire respective dans la direction de connexion série est compris dans une plage de la largeur de cellule entre 2 cm et 10 cm, et/ou le rendement du module solaire à couches minces en fonction d'une largeur de cellule (ZB) de la cellule solaire respective dans la direction de connexion série dans la plage de la largeur de cellule entre 2 cm et 20 cm varie relativement au maximum de 20 %, en particulier relativement au maximum de 10 %.

3. Module solaire à couches minces selon la revendication 1 ou 2, dans lequel une première (2ₘ₋₁) et une troisième cellule solaire (2ₘ₊₁) sont sur des côtés opposés adjacentes à une deuxième cellule solaire (2ₘ), dans lequel la première et la deuxième cellule solaire sont raccordées électriquement en série par une ou plusieurs premières bandes de contact (7a), et la deuxième et la troisième cellule solaire sont raccordées électriquement en série par une ou plusieurs deuxièmes bandes de contact (7b), et chacune des premières bandes de contact met en contact la face, tournée vers la couche absorbante, de la couche à contact arrière de la première cellule solaire et la face, détournée de la couche absorbante, de la couche à contact avant de la deuxième cellule solaire, et chacune des deuxièmes bandes de contact met en contact la face, tournée vers la couche absorbante, de la couche à contact arrière de la deuxième cellule solaire et la couche, détournée de la couche absorbante, de la couche à contact avant de la troisième cellule solaire, et dans lequel, au niveau de la deuxième cellule solaire, au moins une première et une deuxième bande de contact s'étendent en se recouvrant dans la direction transversale à la direction de connexion série.

4. Module solaire à couches minces selon la revendication 3, dans lequel, au niveau d'une cellule solaire respective, les premières bandes de contact sont disposées à une même distance transversale (QA₂) les unes des autres, et/ou les deuxièmes bandes de contact sont disposées à une même distance transversale (QA₂) les unes des autres, et/ou les premières et les deuxièmes bandes de contact sont disposées en alternance à une même distance transversale (QA₁₂) les unes des autres.

5. Module solaire à couches minces selon la revendication 4, dans lequel
- la distance transversale des premières bandes de contact les unes des autres mesure entre 10 mm et 100 mm, et/ou
- la distance transversale des deuxièmes bandes de contact les unes des autres mesure entre 10 mm et 100 mm, et/ou
- la distance transversale des premières et des deuxièmes bandes de contact les unes des autres mesure entre 5 mm et 50 mm.

6. Module solaire à couches minces selon l'une quelconque des revendications 1 à 5, dans lequel le réseau de cellules solaires présente une couche de substrat (15) sur laquelle les cellules solaires sont disposées ensemble, leur couche à contact arrière étant tournée vers la couche de substrat, dans lequel respectivement deux cellules solaires adjacentes et électriquement raccordées en série sont séparées l'une de l'autre dans leur structure en couches par une zone de bande séparatrice (12), et pour le raccordement électriquement en série des deux cellules solaires, les bandes de contact s'étendent au-delà de leur zone de bande séparatrice.

7. Module solaire à couches minces selon l'une quelconque des revendications 1 à 6, dans lequel les bandes de contact sont des composants préfabriqués séparément du réseau de cellules solaires monolithique sous forme d'un matériau en fil ou en bande et placés sur le réseau de cellules solaires monolithique.

8. Module solaire à couches minces selon l'une quelconque des revendications 1 à 7, dans lequel
- au niveau d'une cellule solaire respective, les bandes de contact s'étendent sur une longueur de bande (KL) qui mesure au moins 50 %, en particulier au moins 80 %, de l'étendue longitudinale (SL) de la cellule solaire dans la direction d'étendue des bandes de contact, et/ou
- au niveau d'une cellule solaire respective, les bandes de contact s'étendent avec leur partie de bande en contact avec la couche à contact avant sur une longueur de bande (KL) qui est par rapport à l'étendue longitudinale (SL) de la cellule solaire dans la direction d'étendue des bandes de contact inférieure d'une distance de raccourcissement (VA) qui est au maximum deux fois plus grande, en particulier au maximum aussi grande qu'une distance réticulaire (GA) d'une structure de réseau de contact (13) de la couche à contact avant.

9. Module solaire à couches minces selon la revendication 8, dans lequel l'étendue longitudinale de la cellule solaire respective dans la direction d'étendue des bandes de contact mesure entre 10 mm et 300 mm.

10. Module solaire à couches minces selon l'une quelconque des revendications 1 à 9, dans lequel le rapport longueur/largeur de la surface de contact de la bande de contact respective à la couche à contact arrière est compris dans la plage entre 15:1 et 1000:1 lorsqu'une largeur de cellule (ZB) de la cellule solaire mesure entre 0,5 cm et 30 cm.

11. Procédé permettant de fabriquer un module solaire à couches minces selon l'une quelconque des revendications 1 à 10, comprenant les étapes suivantes consistant à :
- préfabriquer le réseau de cellules solaires monolithique (1),
- former les évidements de raccordement (9),
- placer les bandes de contact (7) dans les zones de bandes de raccordement (8) avec mise en contact électrique avec la couche à contact arrière (3) dans les évidements de raccordement et avec la couche à contact avant (4) des cellules solaires respectivement associées, et
- finir le module solaire à couches minces.

12. Procédé selon la revendication 11, dans lequel, avant la mise en place des bandes de contact (7), la couche isolante (17) est appliquée dans les zones de bande de raccordement (8) sur la couche de contact avant (4) et/ou dans les zones de bande séparatrice (12).

13. Procédé selon la revendication 11 ou 12, dans lequel les bandes de contact (7) sont préfabriquées séparément du réseau de cellules solaires monolithique et placées sur le réseau de cellules solaires monolithique.
